# EUROPEAN PATENT SPECIFICATION

(11) **EP 1 850 373 B1**
(45) Date of publication and mention of the grant of the patent: **14.06.2017**
(21) Application number: 06124375.4
(22) Date of filing: 20.11.2006
(51) Int. Cl.: H01L 21/20, H01L 21/02

(54) **Method of forming highly orientated silicon film, method of manufacturing three-dimensional semiconductor device, and three-dimensional semiconductor device**
Verfahren zur Bildung eines stark orientierten Siliziumfilms, Verfahren zur Herstellung eines dreidimensionalen Halbleiterbauelements und dreidimensionales Halbleiterbauelement
Procédé de formation de film silicone à forte orientation, procédé de fabrication de dispositif semi-conducteur tridimensionnel et dispositif semi-conducteur tridimensionnel

(30) Priority: 25.04.2006 KR 20060037219
(43) Date of publication of application: 31.10.2007
(73) Proprietor: Samsung Electronics Co., Ltd., Suwon-si, Gyeonggi-do, 443-742 (KR)
(72) Inventor: Xianyu, Wenxu, Gyeonggi-do (KR); Park, Young-soo, Gyeonggi-do (KR); Lee, Jun-ho, Gyeonggi-do (KR); Lim, Hyuck, Gyeonggi-do (KR); Cho, Hans S, Gyeonggi-do (KR); Yin, Huaxiang, Gyeonggi-do (KR)
(74) Representative: Portch, Daniel

(56) References cited:
- KANG H C ET AL: "Synthesis of epitaxial [gamma]-Al2O3 thin films by thermal oxidation of AlN/sapphire(0001) thin films" APPLIED PHYSICS A (MATERIALS SCIENCE PROCESSING) SPRINGER-VERLAG GERMANY, vol. A77, no. 5, October 2003 (2003-10), pages 627-632, XP002559708 ISSN: 0947-8396
- ISHIDA M ET AL: "DOUBLE SOI STRUCTURES AND DEVICE APPLICATIONS WITH HETEROEPITAXIAL AL2O3 AND SI" JAPANESE JOURNAL OF APPLIED PHYSICS, JAPAN SOCIETY OF APPLIED PHYSICS, TOKYO,JP, vol. 34, no. 2B, PART 01, 1 February 1995 (1995-02-01), pages 831-835, XP000599408 ISSN: 0021-4922
- "Epitaxial growth of cubic AlN films on (100) and (111) silicon by pulsed laser ablation" APPLIED PHYSICS LETTERS, AIP, AMERICAN INSTITUTE OF PHYSICS, MELVILLE, NY, US, vol. 66, no. 16, 17 April 1995 (1995-04-17), pages 2066-2068, XP012012581 ISSN: 0003-6951
- BRUNET F ET AL: "Highly textured hexagonal AlN films deposited at low temperature by reactive cathodic sputtering" MATERIALS SCIENCE AND ENGINEERING B, ELSEVIER SEQUOIA, LAUSANNE, CH, vol. 59, no. 1-3, 6 May 1999 (1999-05-06), pages 88-93, XP004173211 ISSN: 0921-5107
- ISHIDA M ET AL: 'Epitaxially stacked structures of Si/Al2O3Si for sensor materials' 5TH INTERNATIONAL CONFERENCE ON SOLID-STATE SENSORS AND ACTUATORS AND EUROSENSORS III 25-30 JUNE 1989 MONTREUX, SWITZERLAND vol. A21, no. 1-3, February 1990, SENSORS AND ACTUATORS A (PHYSICAL) SWITZERLAND, pages 267 - 270 ISSN: 0924-4247
- Bong-Chul Ko, Chang-Woo Nam, and Kyu-Chul Lee: "SMaterial and SAW properties of AlN thin film deposited by reactive RFmagnetron sputtering method on various substrates", International Symposium on Electrical & Electronics Engineering 2005, Oct. 11, 12 2005 - HCM City, Vietnam , 12 October 2005 (2005-10-12), Retrieved from the Internet: URL:http://www.nsl.hcmus.edu.vn/greenstone /collect/hnkhbk/index/assoc/HASH1fd3.dir/d oc.pdf [retrieved on 2011-05-16]
- Bong-Chul Ko ET AL: "Material and SAW properties of AlN thin film deposited by reactive RFmagnetron sputtering method on various substrates", International Symposium on Electrical & Electronics Engineering 2005, Oct. 11, 12 2005 - HCM City, Vietnam, 11 October 2005 (2005-10-11), XP55010439,

## Description

### BACKGROUND OF THE INVENTION

The present invention relates to a method of manufacturing a three-dimensional semiconductor device including forming a highly oriented silicon film.

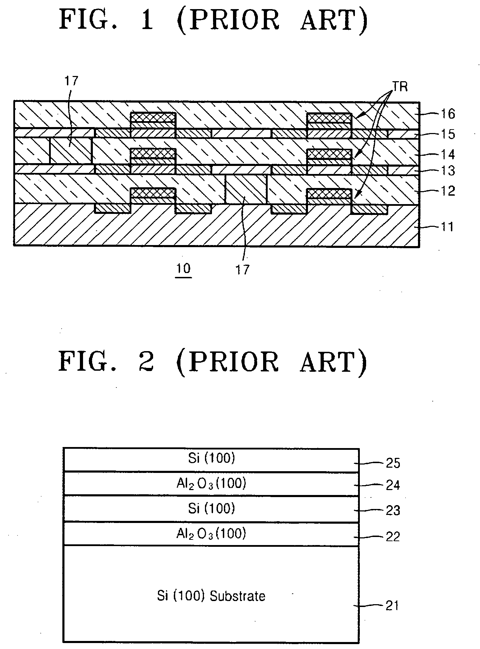

As the requirement of high integration density of semiconductor devices increases, development of three-dimensional semiconductor devices having a plurality of transistors or memory layers has increased. FIG. 1 is a cross-sectional view of a conventional three-dimensional semiconductor device 10. Referring to FIG. 1, the three-dimensional semiconductor device 10 having a structure in which insulating layers 12, 14, and 16 and silicon film layers 13 and 15 are alternately stacked on a silicon substrate 11. A plurality of thin film transistors TR, for example, CMOS or memories are formed on upper surfaces of the silicon substrate 11 and the silicon film layers 13 and 15. The silicon layers 11, 13, and 15 are electrically connected to each other through conductive plugs 17.

To manufacture the three-dimensional semiconductor device, the silicon film layers 13 and 15 stacked on the insulating layers 12 and 14 must have high charge mobility. Accordingly, the silicon film layers 13 and 15 are required to be manufactured to be highly oriented silicon films, close to almost single crystals. However, the technique for epitaxially growing the highly oriented silicon film on an insulating layer has not been developed.

In the prior art, to manufacture a silicon film having high charge mobility on an insulating layer, methods of recrystallizing the silicon film to single crystal silicon through a laser annealing technique after forming amorphous silicon or polycrystalline silicon on the insulating layers 12 and 14, growing the silicon film toward lateral directions from the conductive plugs 17, or bonding an individually grown single crystal silicon film to the insulating layers 12 and 14 have been used. However, these conventional methods are performed at excessively high temperatures, require long processing times, and have high manufacturing costs. Furthermore, the orientation cannot be completely controlled, and, grain boundaries are generated.

A technique for growing silicon layer oriented in a <100> direction on a γ(gamma)-Al₂O₃ layer using an epitaxial method has been disclosed in Ishida et al, "Double SOI Structures and Device Applications with Heteroepitaxial Al2O3 and Si", Japanese Journal of Applied Physics, Vol.34 (1995) pp.831-835. FIG. 2 is a cross-sectional view of a conventional structure used to form a highly oriented silicon film. According to the above article, and referring to FIG. 2, when an Al₂O₃ layer 22 is formed on a silicon substrate 21 oriented in a <100> direction, the Al₂O₃ layer 22 becomes a γ-Al₂O₃ oriented in the <100> direction. When a silicon layer 23 is further epitaxially grown on the γ-Al₂O₃ layer 22, the silicon layer 23 is oriented in the <100> direction. As depicted in FIG. 2, the γ-Al₂O₃ layers 22 and 24 and (100)-silicon layers 23 and 25 can be repeatedly stacked. This is possible because the lattice mismatch between a γ-Al₂O₃ crystal and a (100)-silicon crystal is only between 2.4 to 3.5%.

However, in the prior art, the silicon substrate 21 which is already oriented in the <100> direction is required. Accordingly, it is difficult to use the conventional technique for forming a silicon film on an insulating layer in the three-dimensional semiconductor device depicted in FIG. 1.

Kang et al describe formation of high quality Al2O3 in "Synthesis of epitxial γ-Al2O3 thin films by termal oxidation of AIN/sapphire (0001) thin films, Applied Physics A, volume 77, pages 627 to 632, (2003). AIN is grown on sapphire and the γ**-**Al₂O₃ is formed by oxidation.

Ishida et al, "Epitaxially stacked structures of Si/Al2O3/Si for sensor materials", Sensors and Actuators A21-A23 (1990) pages 267 to 270) describes a stacked structure with epitaxial silicon grown on alumina on a silicon wafer.

Bong-Chul Ko et al, "Smaterial and SAW properties of AIN thin film deposited by reactie RF magnetron sputtering method on various substrates", International Symposium on Electrical and Electronics Engineering 2005, HCM City, Vietnam, teaches the deposition of AIN by magnetron sputtering.

### SUMMARY OF THE INVENTION

According to the invention, there is provided a method of manufacturing a three-dimensional semiconductor device according to claim 1.

The highly oriented AIN film may be oriented in a c-axis on the substrate, and preferably, the highly oriented AIN film may be oriented in a <002> direction.

The highly oriented AIN film may be formed using a sputtering method, a metalorganic chemical vapor deposition (MOCVD) method, a physical vapor deposition (PVD) method, or a chemical vapor deposition (CVD) method.

The highly oriented Al₂O₃ layer is formed by thermal oxidation of the highly oriented AIN film under an oxygen or ozone gas atmosphere.

The highly oriented Al₂O₃ layer may have one of a γ-Al₂O₃ structure and an α-Al₂O₃ structure, or a mixed structure comprising the γ-Al₂O₃ structure and the α-Al₂O₃ structure.

The thermal oxidation may be performed at a temperature of 500 to 1000°C.

The highly oriented Al₂O₃ layer is oriented in a <001 > direction.

The method may further comprise washing a surface of the highly oriented Al₂O₃ layer after the highly oriented Al₂O₃ layer is formed. The washing of the surface of the highly oriented Al₂O₃ layer may be performed using a diluted HF solution.

The growing of the highly oriented silicon film may be performed using an ultra-high vacuum chemical vapor deposition (UHV CVD) method, a low pressure chemical vapor deposition (LPCVD) method, or a molecular beam epitaxy (MBE) method.

The silicon film may be oriented in the <001> direction.

The interlayer insulating layer may be formed of at least one of the group consisting of SiO₂, Si₃N₄, and Al₂O₃.

The method of manufacturing the 3-D semiconductor device may include the forming of an interlayer insulating layer on the highly oriented silicon film on which the second electronic device is formed; the forming of a highly oriented AIN film oriented in a direction on the interlayer insulating layer; the forming of a highly oriented Al₂O₃ layer on a surface of the AIN film by oxidizing the highly oriented AIN film; the growing of a highly oriented silicon film on the highly oriented Al₂O₃ layer; and the forming of a third electronic device on the highly oriented silicon film.

A three-dimensional semiconductor device may be manufactured using the above method.

The present invention provides a method of forming a highly oriented silicon film, the method can be performed at a low temperature, is compatible with a conventional semiconductor manufacturing process, and can effectively control the orientation of silicon film.

The present invention also provides a method of manufacturing a three-dimensional semiconductor device using the highly oriented silicon film, and the three-dimensional semiconductor device manufactured using the above method.

### BRIEF DESCRIPTION OF THE DRAWINGS

The above and other features and advantages of the present invention will become more apparent by describing in detail exemplary embodiments thereof with reference to the attached drawings in which:
FIG. 1 is a cross-sectional view of a conventional three-dimensional semiconductor device;
FIG. 2 is a cross-sectional view of a conventional structure used to form a highly oriented silicon film;
FIGS. 3A through 3C are cross-sectional views illustrating a method of forming a highly oriented silicon film according to an embodiment of the present invention;
FIG. 4 is a graph showing the results of X-ray diffraction (XRD) on a AIN thin film oriented in a <200> direction; and
FIG. 5 is a cross-sectional view illustrating a stacking structure of a plurality of highly oriented silicon films according to an embodiment of the present invention.

### DETAILED DESCRIPTION OF THE INVENTION

The present invention will now be described more fully with reference to the accompanying drawings in which exemplary embodiments of the invention are shown.

A technique for forming a highly oriented silicon film by epitaxially growing silicon on a highly oriented γ-Al₂O₃ layer after a highly oriented Al₂O₃ layer 22 is formed on a silicon layer which is already oriented in a predetermined direction is well known in the art. However, a technique for epitaxially growing a highly oriented silicon film on an insulating layer has not yet been developed. The present invention provides a method of forming a highly oriented silicon film by forming a buffer layer formed of aluminum nitride (AIN) on an insulating layer.

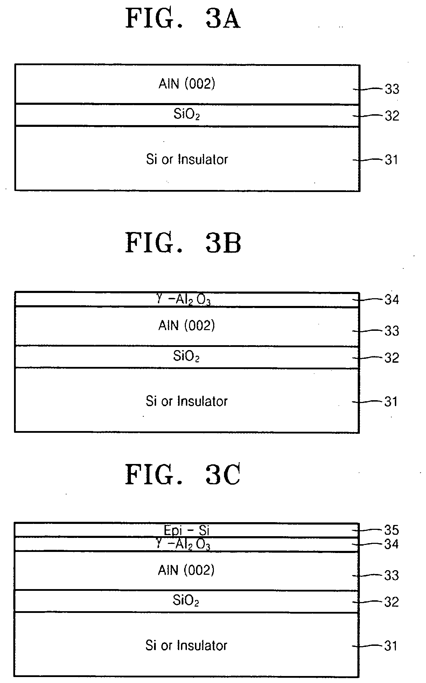

FIGS. 3A through 3C are cross-sectional views illustrating a method of forming a highly oriented silicon film according to an embodiment of the present invention.

Referring to FIG. 3A, a SiO₂ layer 32 acting as an insulating layer is formed on a silicon substrate 31, and a highly oriented AIN film 33 oriented in a predetermined direction is formed on the SiO₂ layer 32. Here, the silicon substrate 31 and the SiO₂ layer 32 are depicted to show that they can correspond to a silicon substrate 11 and an insulating layer 12 of a three-dimensional semiconductor device of FIG. 1. However, only in forming the AIN film 33, the SiO₂ layer 32 without the silicon substrate 31 can serve as a substrate. Also, other materials, for example, Si₃N₄ or Al₂O₃ can be used as the insulating layer 32 besides SiO₂, or at least one of these materials described above can be used as the insulating layer 32. Even if the substrate 31 is formed of another semiconductor material or an insulating material besides silicon, it does not affect the formation of the AIN film 33.

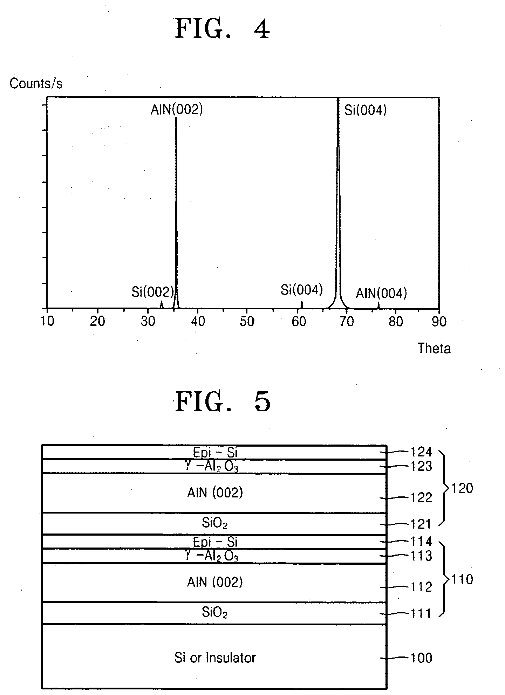

According to an embodiment of the present invention, the AIN film 33 can be formed using, for example, a sputtering method, a metalorganic chemical vapor deposition (MOCVD) method, a physical vapor deposition (PVD) method, or a chemical vapor deposition (CVD) method. It is confirmed that the AIN film 33 formed on SiO₂ or Si₃N₄ using the above methods is very uniformly oriented in a direction perpendicular to an upper surface of the substrate 31, that is, to a c-axis. FIG. 4 is a graph showing the results of X-ray diffraction (XRD) on an AIN film formed using the above method. The AIN film of FIG. 4 was formed at room temperature using a sputtering method by supplying nitrogen and argon gases at flow rates of 39sccm and 6sccm respectively with a power supply of approximately 7000W AC. As shown in FIG. 4, peaks in <002> and <004> directions are shown since the AIN film 33 is c-axis oriented. In particular, a large peak is shown in the <002> direction. This shows that almost all of the AIN film 33 is oriented in the <002> direction.

There is no specific limitation of the thickness of the AIN film 33, but it may be as thin as possible to aid in manufacturing a three-dimensional semiconductor device. However, considering that as the thickness of the AIN film 33 increases, the orientation of the AIN film 33 becomes more uniform, the AIN film 33 may have a thickness of 30 to 500nm.

Referring to FIG. 3B, a highly oriented γ-Al₂O₃ layer or α-Al₂O₃ layer 34 is formed on a surface of the AIN film 33 by oxidizing the highly oriented AIN film 33. For example, the highly oriented γ-Al₂O₃ layer or α-Al₂O₃ layer 34 can be simply formed by thermally oxidizing the highly oriented AIN film 33 at a temperature of 500 to 1000°C in an oxygen or ozone gas atmosphere. Here, it is preferable that the heating temperature is a temperature of the higher end of the temperature range. In this process, nitrogen is removed from the surface of the AIN film 33, and Al₂O₃ is formed by combining oxygen with aluminum. According to heating time and temperature used, a γ-Al₂O₃ layer or an α-Al₂O₃ layer can be formed, or a mixed layer comprised of γ-Al₂O₃ and α-Al₂O₃ can be formed. However, whichever of the aforementioned layers is formed has no affect on the subsequent process for forming a silicon film 35. The Al₂O₃ formed in this way is a crystal having a short-range order, and is oriented in the c-axis direction almost perpendicular to an upper surface of the substrate 31 like the AIN film 33. For example, the Al₂O₃ in this case is γ-Al₂O₃ or α-Al₂O₃ oriented in the <001> direction.

After the highly oriented γ-Al₂O₃ layer or α-Al₂O₃ layer 34 is formed on the highly oriented AIN film 33 according to the above method, a surface of the highly oriented γ-Al₂O₃ layer or α-Al₂O₃ layer 34 is washed using, for example, a diluted HF solution to remove remaining impurities from the surface.

Referring to FIG. 3C, the silicon film 35 is formed on the highly oriented γ-Al₂O₃ layer or α-Al₂O₃ layer 34. As described above, the technique for forming a highly oriented silicon film on a highly oriented γ-Al₂O₃ layer by epitaxially growing silicon is well known in the art. A highly oriented (100)-silicon film can be formed when silicon is epitaxially grown on the highly oriented γ-Al₂O₃ layer since the lattice mismatch between a γ-Al₂O₃ crystal and a highly oriented (100)-silicon crystal is only 2.4 to 3.5%. The highly oriented α-Al₂O₃ layer having a crystal structure which is more stable than the highly oriented γ-Al₂O₃ layer can perform the role of the highly oriented γ-Al₂O₃ layer. The silicon film 35 can be grown on the highly oriented γ-Al₂O₃ layer or α-Al₂O₃ layer 34 using, for example, a ultra-high vacuum chemical vapor deposition (UHV CVD) method, a low pressure chemical vapor deposition (LPCVD) method, or a molecular beam epitaxy (MBE) method. For example, in the present embodiment, the silicon film 35 is grown at a temperature of 550-800°C with a pressure of approximately 10⁻³ torr under a SiH₄ gas atmosphere using the UHV CVD method.

As described above, according to an embodiment of the present invention, the formation of the silicon film on an insulating layer is possible by forming a buffer layer using AIN. Accordingly, if the highly oriented silicon films are stacked using the present invention, a three-dimensional semiconductor device in which electronic devices such as thin film transistors or memories are stacked can be simply and inexpensively manufactured in comparison to the conventional method.

FIG. 5 is a cross-sectional view illustrating a stacking structure of a plurality of highly oriented silicon films according to an embodiment of the present invention. Referring to FIG. 5, a SiO₂ layer 111 acting as an interlayer dielectric (ILD) film is formed on a silicon substrate 100, and a highly oriented AIN film 112, a highly oriented γ-Al₂O₃ layer 113, and a highly oriented silicon film 114 are sequentially stacked on the SiO₂ layer 111. Here, the SiO₂ layer 111, the highly oriented AIN film 112, the highly oriented γ-Al₂O₃ layer 113, and the highly oriented silicon film 114 constitute a first multilayer 110. The ILD film can be formed of Si₃N₄ or Al₂O₃ instead of SiO₂. Also, according to the present invention, a second multilayer 120 consists of a SiO₂ layer 121, a highly oriented AIN film 122, a highly oriented γ-Al₂O₃ layer 123, and a highly oriented silicon film 124. The second multilayer 120 can be formed on the highly oriented silicon film 114. Although it is not depicted, more multilayers can be continuously stacked on the silicon film 124.

A three-dimensional semiconductor device, functionally equivalent to the device depicted in FIG. 1 can be manufactured by forming thin film transistors such as CMOS devices or electronic devices such as memory devices on upper surfaces of the silicon substrate 100 and the highly oriented silicon films 114 and 124 in the structure depicted in FIG. 5. More specifically, an electronic device such as a thin film transistor or a memory can be formed on the silicon substate 100 by forming a gate insulating layer (not shown) and a gate electrode (not shown) between two doped regions which can be formed by doping an n-dopant and a p-dopant on specific regions of the silicon substrate 100 using a method well known in the art. Afterwards, the SiO₂ layer 111, the highly oriented AIN film 112, the highly oriented γ-Al₂O₃ layer 113, and the highly oriented silicon film 114 are sequentially formed on the silicon substrate 100. Again, an electronic device such as a thin film transistor or a memory can be formed on an upper surface of the highly oriented silicon film 114 using the same method as described above. By repeating this process, the three-dimensional semiconductor device can be manufactured.

As described above, according to the present invention, a highly oriented silicon film can be formed on an insulating layer by forming a buffer layer using AIN. Furthermore, the highly oriented silicon film according to the present invention can be manufactured using a low temperature process and using a process compatible with the conventional manufacturing process. Accordingly, the use of the present invention allows the manufacture of a three-dimensional semiconductor device at low cost and using a simpler process than a conventional process.

While the present invention has been particularly shown and described with reference to exemplary embodiments thereof, it will be understood by those of ordinary skill in the art that various changes in form and details may be made therein without departing from the scope of the present invention as defined by the following claims.

## Claims

1. A method of manufacturing a three-dimensional semiconductor device, comprising:
forming an interlayer insulating layer (111) on a silicon substrate (100) on which silicon substrate a first electronic device is formed;
forming a highly oriented AIN film (112) oriented in a specific direction on the first interlayer insulating layer (111);
forming a highly oriented Al₂O₃ layer (113) on an upper surface of the highly oriented AIN film (112) by oxidizing only the upper surface of the highly oriented AIN film (112);
growing a highly oriented silicon film (114) on the highly oriented Al₂O₃ layer (113); and
forming a second electronic device on the highly oriented silicon film (114).

2. The method of claim 1 wherein the interlayer insulating layer (111) is formed of at least one of the group consisting of SiO₂, Si₃N₄, and Al₂O₃.

3. The method of claim 1, further comprising
the forming of an interlayer insulating layer (121) on the highly oriented silicon film (114) on which the second electronic device is formed;
the forming of a highly oriented AIN film (122) oriented in a direction on the interlayer insulating layer;
the forming of a highly oriented Al₂O₃ layer (123) on a surface of the AIN film by oxidizing the highly oriented AIN film;
the growing of a highly oriented silicon film (124) on the highly oriented Al₂O₃ layer; and
the forming of a third electronic device on the highly oriented silicon film.

## Patentansprüche

1. Verfahren zur Herstellung eines dreidimensionalen Halbleiterbauelements, umfassend:
Ausbilden einer Zwischenschicht-Isolationsschicht (111) auf einem Siliziumsubstrat (100), wobei auf dem Siliziumsubstrat ein erstes elektronisches Bauelement ausgebildet wird;
Ausbilden einer hochorientierten AIN-Folie (112), die in einer spezifischen Richtung auf der ersten Zwischenschicht-Isolationsschicht (111) ausgerichtet ist;
Ausbilden einer hochorientierten Al₂O₃-Schicht (113) auf einer oberen Oberfläche der hochorientierten AIN-Folie (112) durch Oxidieren nur der oberen Oberfläche der hochorientierten AIN-Folie (112);
Wachsen einer hochorientierten Siliziumfolie (114) auf der hochorientierten Al₂O₃-Schicht (113); und
Ausbilden eines zweiten elektronischen Bauelements auf der hochorientierten Siliziumfolie (114).

2. Verfahren nach Anspruch 1, wobei die Zwischenschicht-Isolationsschicht (111) ausgebildet ist aus wenigstens einer Substanz der Gruppe bestehend aus SiO₂, Si₃N₄ und Al₂O₃.

3. Verfahren nach Anspruch 1, ferner umfassend:
das Ausbilden einer Zwischenschicht-Isolationsschicht (121) auf der hochorientierten Siliziumfolie (1149, auf welcher das zweite elektronische Bauelement ausgebildet wird;
das Ausbilden einer hochorientierten AIN-Folie (122), die in einer spezifischen Richtung auf der Zwischenschicht-Isolationsschicht ausgerichtet ist;
das Ausbilden einer hochorientierten Al₂O₃-Schicht (123) auf einer Oberfläche der AIN-Folie durch Oxidieren hochorientierten AIN-Folie;
das Wachsen einer hochorientierten Siliziumfolie (124) auf der hochorientierten Al₂O₃-Schicht; und
das Ausbilden eines dritten elektronischen Bauelements auf der hochorientierten Siliziumfolie.

## Revendications

1. Procédé de fabrication d'un dispositif semi-conducteur tridimensionnel comprenant les étapes consistant à :
former une couche isolante intercouche (111) sur un substrat de silicium (100), substrat de silicium sur lequel un premier dispositif électronique est formé ;
former un film AIN à forte orientation (112) orienté dans une direction spécifique sur la première couche isolante intercouche (111) ;
former une couche Al₂O₃ à forte orientation (113) sur une surface supérieure du film AIN à forte orientation (112) en oxydant seulement la surface supérieure du film AIN à forte orientation (112) ;
cultiver un film de silicium à forte orientation (114) sur la couche Al₂O₃ à forte orientation (113) ; et
former un deuxième dispositif électronique sur le film de silicium à forte orientation (114).

2. Procédé selon la revendication 1, la couche isolante intercouche (111) étant formée d'au moins un élément du groupe constitué par SiO₂, Si₃N₄, et Al₂O₃.

3. Procédé selon la revendication 1, comprenant en outre les étapes consistant à
former une couche isolante intercouche (121) sur le film de silicium à forte orientation (114) sur lequel est formé le deuxième dispositif électronique ;
former un film AIN à forte orientation (122) orienté dans une direction sur la couche isolante intercouche ;
former une couche de Al₂O₃ à forte orientation (123) sur une surface du film AIN en oxydant le film AIN à forte orientation ;
cultiver un film de silicium à forte orientation (124) sur la couche Al₂O₃ à forte orientation ; et
former un troisième dispositif électronique sur le film de silicium à forte orientation.
